# EUROPÄISCHE PATENTANMELDUNG

(11) **EP 4 276 432 A1**
(43) Veröffentlichungstag der Anmeldung: **15.11.2023**
(21) Anmeldenummer: 23171321.5
(22) Anmeldetag: 03.05.2023
(51) Int. Cl.: G01K 11/3206, G01K 1/143, G01K 1/02, H01M 10/48

(54) **OPTISCH ARBEITENDER TEMPERATURSENSOR, VERWENDUNG DES TEMPERATURSENSORS UND BATTERIEZELLENANORDNUNG MIT WENIGSTENS EINEM TEMPERATURSENSOR**

(30) Priorität: 13.05.2022 EP 22173174
(71) Anmelder: Kistler Holding AG, 8408 Winterthur (CH)
(72) Erfinder: Gragert, Marian, 72172 Sulz (DE)

(57) **Zusammenfassung**

Die Erfindung betrifft einen optisch arbeitenden Temperatursensor (10), mit wenigstens einer Glasfaserleiter (11 bis 13) zur Führung von Lichtstrahlen, mit mehreren, in der wenigstens einen Glasfaserleiter (11 bis 13) axial zueinander beabstandet angeordneten optischen Elementen (21, 22) zur Beeinflussung der in die wenigstens eine Glasfaserleiter (11 bis 13) einleitbaren Lichtstrahlen, wobei die optischen Elemente (21, 22) und der wenigstens einen Glasfaserleiter (11 bis 13) zwischen den optischen Elementen (21, 22) zusammen mit einem Schutzelement (30) eine Baugruppe (31) ausbilden.

## Beschreibung

### Technisches Gebiet

Die Erfindung betrifft einen optisch arbeitenden Temperatursensor, wie er insbesondere dazu dient, eine Oberflächentemperatur an einer Batteriezelle eines Elektrofahrzeugs zu detektieren. Die Temperaturmessung erfolgt mit Blick darauf, Be- oder Vorschädigungen an der Batteriezelle durch zu hohe oder zu niedrige Temperaturen der Batteriezelle im Zusammenhang mit hohen elektrischen Belastungen der Batteriezelle zu vermeiden.

### Stand der Technik

Aus der WO 2019/166765 A1 ist eine Sensoranordnung unter Verwendung mehrerer Glasfaserleiter bekannt, die in einem axialen Abstand zueinander angeordnete optische Elemente in Form von Reflektoren aufweisen. Die aus der bekannten Schrift offenbarte Sensoranordnung dient der Detektion einer geometrischen Verformung der Glasfaserleiter. Derartige Deformationen treten, wie an sich bekannt, zum einen dann auf, wenn die Glasfaserleiter durch äußere Kräfte deformiert bzw. verformt werden. Weiterhin können derartige Deformationen ebenfalls dann auftreten, wenn die Glasfaserleiter aufgrund einer Temperaturänderung infolge ihres Wärmeausdehnungskoeffizienten ihre Länge verändern. Möglichkeiten, diese unterschiedliche Ursachen aufweisenden Deformationen zu differenzieren, sind in der genannten Schrift nicht offenbart.

### Darstellung der Erfindung

Der erfindungsgemäße optisch arbeitende Temperatursensor mit den Merkmalen des Anspruchs 1 hat den Vorteil, dass er es ermöglicht, ausschließlich solche Deformationen bzw. Verformungen von Glasfaserleitern zu detektieren, die durch eine Temperaturänderung der Glasfaserleiter verursacht werden. Insbesondere lassen sich dadurch Falschmessungen verursacht durch Deformationen ausschließen, die aufgrund äußerer Krafteinwirkungen auf die Glasfaserelemente bzw. Glasfaserleiter entstehen. Weiterhin kann der erfindungsgemäße Temperatursensor auch für die Temperaturmessung bei elektrisch leitenden bzw. spannungsführenden Bauteilen eingesetzt werden, wobei der Temperatursensor eine hohe Genauigkeit und kurze Ansprechzeit aufweist.

Insbesondere bei spannungsführenden Bauteilen sind metallische, beziehungsweise elektrisch leitende Elemente nachteilig, da durch sie Gefahr von Kurzschlüssen erhöht ist. Elektrisch Temperatursensoren, beispielsweise Widerstandsthermometer und alle mit elektrischen Leitern verbundene Temperatursensoren weisen diesen Nachteil auf. Der erfindungsgemässe unterliegt nicht diesem Mangel.

Der Erfindung liegt die Idee zugrunde, die Glasfaserleiter in Wirkverbindung mit einem Schutzelement derart anzuordnen, dass äußere Kräfte von dem Schutzelement aufgenommen werden und nicht in die Glasfaserleiter eingeleitet werden, um dort zu Deformationen zu führen. Mit anderen Worten gesagt, besteht der Kern der Erfindung darin, von den Glasfaserleitern äußere Kräfte fernzuhalten, sodass eine Änderung der Geometrie der Glasfaserleiter zwischen den optischen Elementen lediglich aufgrund einer Temperaturänderung, d.h. aufgrund des Wärmeausdehnungsverhaltens der Glasfaserleiter, erfolgt.

Vor dem Hintergrund der obigen Erläuterungen ist es daher bei einem optisch arbeitenden Temperatursensor mit den Merkmalen des Anspruchs 1 vorgesehen, dass der Temperatursensor wenigstens einen Glasfaserleiter zur Führung von Lichtstrahlen aufweist, sowie mehrere, in dem wenigstens einen Glasfaserleiter axial zueinander beabstandet angeordnete optische Elemente zur Beeinflussung der in die Glasfaserleiter einleitbaren Lichtstrahlen, wobei die optischen Elemente und der wenigstens eine Glasfaserleiter zwischen den optischen Elementen zusammen mit einem starren Schutzelement eine mit einem Messobjekt verbindbare Baugruppe ausbilden, wobei das Schutzelement zumindest auf der einer Oberfläche des Messobjekts zugewandten und mit dem Messobjekt verbindbaren Seite elektrisch isoliert ausgebildet ist.

Unter starr wird ein Schutzelement verstanden, dessen Biegeverformung um einen Biegeradius eine mindestens 10 mal höhere Kraft benötigt als eine Biegeverformung um denselben Biegeradius des Glasfaserleiters. Je nach erwarteten Kräften in der Anwendung kann selbstverständlich auch eine höhere Starrheit vorteilhaft sein.

Die Reflektoren oder Materialveränderungen in der Glasfaser zur Veränderung der optischen Eigenschaften sind die signalerzeugenden Messstellen. Kern der Erfindung ist der Schutz dieser Messstellen mit einem elektrisch isolierenden Schutzelement, welches die Messstelle vor ungewünschten Umwelteinflüssen schützt.

Vorteilhafte Weiterbildungen des erfindungsgemäßen Temperatursensors sind in den Unteransprüchen aufgeführt.

Vorteilhaft besteht das Schutzelement aus einem Material mit einer Wärmeleitfähigkeit von mindestens 0,1 Watt je Meter und Kelvin.

Vorteilhaft weist das Schutzelement einen vergleichbaren Wärmeausdehnungskoeffizienten wie die Glasfaser selbst auf. Unter einem vergleichbaren Wärmeausdehnungskoeffizienten wird eine Abweichung der Wärmeausdehnungskoeffizienten von nicht mehr als 20% verstanden. Bei grösseren Abweichungen ist der mechanische Einfluss des Schutzelements auf den Glasfaserleiter auf Grund der Unterschiede im Wärmeausdehnungskoeffizienten bei einer Veränderung der zu bestimmenden Temperatur derart, dass eine genaue Bestimmung der Temperatur erschwert ist.

Das Schutzelement weist mit der Faser stoffschlüssig verbunden werden und ist dann als eine Baugruppe anzusehen. Dadurch wird eine Entkopplung von mechanischen und chemischen Einflüssen außerhalb dieser Baugruppe sichergestellt.

In einer bevorzugten konstruktiven Ausgestaltung des Schutzelements ist dieses vorzugsweise als Rohr ausgebildet. Mit anderen Worten gesagt bedeutet dies, dass das Schutzelement aufgrund seiner Geometrie den Querschnitt der wenigstens einen Glasfaserleiter vollständig umgibt. Dadurch wird es zuverlässig vermieden, dass äußere Krafteinflüsse auf den bzw. die Glasfaserleiter einwirken und dort zu Deformationen führen.

Besonders bevorzugt ist das Schutzelements als geradlinig ausgebildetes Rohr ausgebildet.

Hinsichtlich des Materials für das Schutzelement gibt es unterschiedliche Möglichkeiten. Beispielsweise kann das Material aus Keramik oder einem Glaswerkstoff oder einem Kunststoff, beispielsweise Polyetheretherketon (PEEK) oder Polytetrafluorethylen (PTFE), Polyethylenterephthalat (PET), Kunstharz, Epoxidharz (EP), bestehen. Die genannten Materialien haben typischerweise alle die Eigenschaft, dass sie elektrisch isolierend ausgebildet sind und daher keine zusätzliche Beschichtung o.ä. benötigen, damit das Schutzelement auf der dem Messobjekt zugewandten Seite elektrisch isolierend ausgebildet ist. Es versteht sich, dass neben dem geeigneten Material das Schutzelement auch eine geeignete Geometrie bzw. Materialstärke aufweisen muss, um einerseits Deformationen des Schutzelements zu vermeiden, und andererseits einen möglichst guten bzw. ungehinderten Wärmeübergang von dem Messobjekt in die Glasfaserleiter zu ermöglichen.

Der Temperaturbereich für den Einsatz umfasst bevorzugt zwischen -35°C und 700°C. Die Spitzentemperaturen von 700°C treten beispielsweise bei der Thermal Runaway oder Thermal Propagation Bewertung auf. In diesem Fall ist das Schutzelement aus einem thermisch beständigen Material ausgeführt. In einer weiteren Anwendung der Batterieerprobung beträgt der Temperaturbereich zwischen -35°C und 200°C.

Besonders bevorzugt ist es darüber hinaus, wenn der wenigstens eine Glasfaserleiter und das Schutzelement unmittelbar miteinander verbunden sind. Dies kann beispielsweise durch die Verwendung von (zunächst flüssigem) Glas oder Glaslot als Material für das Schutzelement erfolgen.

Alternativ ist es auch möglich, dass der wenigstens eine Glasfaserleiter und das Schutzelement mittels eines Wärmeleitklebstoffs miteinander verbunden sind. Dies verbessert den Wärmeübergang zwischen dem Schutzelement und der wenigstens einen Glasfaserleiter.

Insbesondere im Zusammenhang bei der Verwendung von Glaswerkstoff für das Schutzelement ist es vorgesehen, dass der Glaswerkstoff die gleiche chemische Zusammensetzung aufweist wie der wenigstens eine Glasfaserleiter. Dies ermöglicht eine einfachere Anpassung der Baueinheit mit Blick auf die möglichst gleiche Wärmeausdehnungskoeffizienten der Glasfaserleiter und dem Glaswerkstoff bzw. dem Schutzelement. Weiterhin kann bei Verwendung von beispielsweise Glaslot für das Schutzelement das Material des Schutzelements auch dazu dienen, eine stoffschlüssige Verbindung mit dem Messobjekt ohne zusätzliche Hilfsstoffe auszubilden. Diese stoffliche Verbindung zur Verbesserung der Wärmeleitfähigkeit kann ebenfalls mit Wärmeleitkleber hergestellt werden.

Auch hinsichtlich der Technologie, welche der Detektion der Temperatur zugrunde liegt, gibt es unterschiedliche Möglichkeiten. Insbesondere hat der erfindungsgemäße Temperatursensor den Vorteil, dass er je nach Anwendungsfall eine Temperaturmessung auf unterschiedlichen Technologien ermöglicht, ohne dass hierzu besondere Anpassungen insbesondere am Schutzelement erforderlich sind. So ist es in einer ersten Ausgestaltung vorgesehen, dass der Temperatursensor dazu ausgebildet ist, eine Temperaturerfassung auf Grundlage einer FSI (Fiber Segment Interferometry) - Technologie zu ermöglichen. Eine derartige Technologie ist in der eingangs erwähnten WO 2019/166765 A1 beschrieben.

Alternativ hierzu ist es auch möglich, dass der Temperatursensor dazu ausgebildet ist, eine Temperaturerfassung auf Grundlage einer an sich bekannten FBG (Fiber Bragg Gratings) -Technologie zu ermöglichen.

Wie bereits oben erläutert, findet der erfindungsgemäße Temperatursensor insbesondere Verwendung zur Erfassung einer Oberflächentemperatur einer Batteriezelle, insbesondere einer Batteriezelle eines Elektrofahrzeugs.

Zuletzt umfasst die Erfindung auch eine Batteriezellenanordnung eines Elektrofahrzeugs mit mehreren Batteriezellen und wenigstens einem, vorzugsweise mehreren erfindungsgemäß ausgebildeten Temperatursensoren, wobei der wenigstens eine Temperatursensor wärmeleitend mit der Oberfläche einer Batteriezelle verbunden ist.

Weitere Vorteile, Merkmale und Einzelheiten der Erfindung ergeben sich aus der nachfolgenden Beschreibung bevorzugter Ausführungsformen der Erfindung sowie anhand der Zeichnungen.

### Kurze Beschreibung der Zeichnungen

Im Folgenden wird die Erfindung beispielhaft unter Beizug der Figuren näher erklärt.
- Fig. 1: zeigt in einer vereinfachten Darstellung eine aus mehreren Batteriezellen bestehende Anordnung für ein Elektrofahrzeug mit daran angeordneten bzw. befestigten optisch arbeitenden Temperatursensoren und
- Fig. 2: eine Prinzipdarstellung eines optisch arbeitenden Temperatursensors gemäß der Fig. 1.

### Wege zur Ausführung der Erfindung

Gleiche Elemente bzw. Elemente mit gleicher Funktion sind in den Figuren mit den gleichen Bezugsziffern versehen.

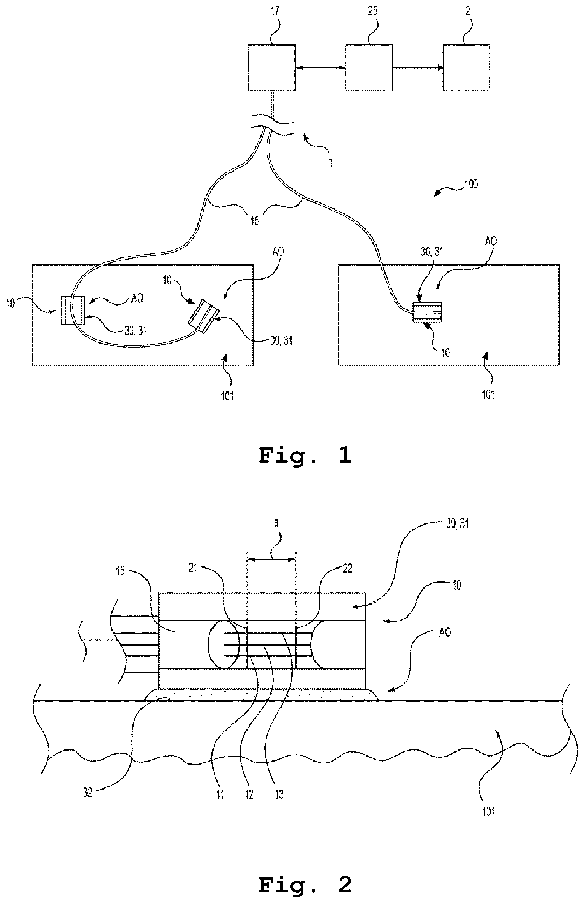

In der Fig. 1 ist eine Batteriezellenanordnung 100 stark vereinfacht dargestellt, wie sie insbesondere als Bestandteil eines Elektrofahrzeugs zum Antrieb des Elektrofahrzeugs dient. Die Batteriezellenanordnung 100 umfasst eine Vielzahl von Batteriezellen 101, typischerweise in Form von flachen (pouch) bzw. quaderförmigen (prismatic) oder runden (round) Lithium-Ionen-Batteriezellen, die elektrisch in Reihe bzw. parallel miteinander verschaltet sind (nicht dargestellt), wobei der Einfachheit halber in der Darstellung der Fig. 1 lediglich zwei Batteriezellen 101 dargestellt sind. Beim Betrieb einer derartigen Batteriezellenanordnung 100 ist es wesentlich, dass die einzelnen Batteriezellen 101 in einem bestimmten Temperaturfenster arbeiten, um einerseits ihre volle Leistungsfähigkeit zu entwickeln, und andererseits Beschädigungen oder Vorschädigungen durch zu hohe oder zu niedrige Temperaturen zu vermeiden. Dazu ist es aus dem Stand der Technik an sich bekannt, die Batteriezellenanordnung 100 mittels einer Heizeinrichtung oder einer Kühleinrichtung (Thermomanagementsystem) in dem gewünschten Temperaturfenster zu halten.

Um die Temperatur der Batteriezellen 101 hinsichtlich der gewünschten Temperatur zu erfassen, ist wenigstens eine der Batteriezellen 101, im dargestellten Ausführungsbeispiel beide Batteriezellen 101, mittels einer Sensoreinrichtung 1 zur Erfassung einer Oberflächentemperatur einer Batteriezelle 101 ausgestattet. Die Sensoreinrichtung 1 erfasst die Temperatur T an der wenigstens einen, ein Messobjekt darstellenden Batteriezelle 101 und leitet die erfassten Daten beispielsweise an eine Steuereinrichtung 2 weiter, die beispielsweise zumindest indirekt die Antriebsleistung des Elektrofahrzeugs regelt oder aber die angesprochene Heiz- bzw. Kühleinrichtung aktiviert, um die Temperatur T der Batteriezellen 101 in dem gewünschten Temperaturfenster zu halten. In der Serienanwendung setzen die Fahrzeughersteller dabei auf wenige mit Messstellen versehene Batteriezellen. In der Entwicklungsanwendung ist eine Erfassung von einer Vielzahl an Messstellen für die Auslegung, Simulation und Überprüfung der Prototypen relevant wodurch die klassische Temperaturmesstechnik durch ihre elektrisch leitenden Kabel an Grenzen stößt. Faseroptische Messtechnik wird durch gegebenenfalls auftretende mechanische Krafteinflüsse kritisch gesehen, da diese Krafteinflüsse das Messergebnis verfälschen können. An dieser Stelle setzt die Erfindung an und liefert optische Fasermesstechnik, welche sich zur Temperaturmessung an stromführenden oder spannungsführenden Bauteilen eignet. Bevorzugt weist die optische Fasermesstechnikeine hohe Anzahl an Messstellen pro Glasfaser und eine Erfassungseinheit für mehrere Glasfasern auf. Die zu erzielende Genauigkeit der Temperaturwerte wird durch die hier genannte Baugruppe mit Schutzelement erzielt.

Die Sensoreinrichtung 1 weist beispielhaft mehrere erfindungsgemäß ausgebildete Temperatursensoren 10 auf, wobei im dargestellten Ausführungsbeispiel an der einen Batteriezelle 101 an deren Oberfläche zwei Temperatursensoren 10, und an der anderen Batteriezelle 101 (lediglich) ein Temperatursensor 10 angeordnet sind. Selbstverständlich liegt es im Rahmen der Erfindung, auch mehr als zwei Temperatursensoren 10 an einer Batteriezelle 101 anzuordnen. Hinsichtlich der Anordnung eines Temperatursensors 10 ist es wesentlich bzw. wünschenswert, dass der bzw. die Anbauorte AO derart gewählt sind, dass eine für die Batteriezelle 101 charakteristische Temperatur T erfasst werden kann, beispielsweise an einer Stelle, an der die Batteriezelle die höchste oder die niedrigste oder eine mittlere Temperatur T auftritt. Dies lässt in der Regel Rückschlüsse auf die Stromdichte in der Batteriezelle an der Messstelle oder auf die Kühlung zu.

Die identisch ausgebildeten optisch arbeitenden Temperatursensoren 10 weisen beispielhaft jeweils drei Glasfaserleiter 11 bis 13 in Form von Hohlleitern auf, welche über einen gemeinsamen Glasfaserstrang 15 zusammengefasst bzw. gebündelt sind. Entsprechend der Darstellung der Fig. 1 sind die Temperatursensoren 10 mit einer lediglich symbolisch darstellten Einrichtung 17 zur Erzeugung von Licht, insbesondere von Laserstrahlen, gekoppelt, wobei die Einrichtung 17 dazu ausgebildet ist, die Lichtstrahlen in die Glasfaserleiter 11 bis 13 einzukoppeln. Weiterhin können die einzelnen Glasfaserleiter 11 bis 13 ggf. jeweils mit einer nicht dargestellten Schutzummantelung versehen sein.

Am Anbauort AO des jeweiligen Temperatursensors 10 an der Batteriezelle 101 weist der entsprechende Abschnitt des Glasfaserstrangs 15 darüber hinaus wenigstens zwei, in einem axialen Abstand a zueinander angeordnete optische Elemente 21, 22 auf. Die optischen Elemente 21, 22 sind beispielsweise in Form von Reflektoren oder optischen Gittern ausgebildet, derart, dass eine Änderung des Abstands a sich in einer Änderung von optischen Eigenschaften des in die Glasfaserleiter 11 bis 13 eingekoppelten Lichts äußert, wobei die optischen Eigenschaften des Lichts mittels einer Auswerteeinrichtung 25 erfassbar sind.

Insbesondere wendet der Temperatursensor 10 ein Messprinzip an, das auf einer FSI-Technologie oder aber einer FBG-Technologie basiert. Mit Blick auf die FSI-Technologie wird beispielhaft auf die WO 2019/166765 A1 verwiesen, in der das physikalische Prinzip erläutert wird, und die insofern Bestandteil dieser Anmeldung sein soll.

Um eine Änderung des Abstands a zu detektieren, die alleine aufgrund einer Temperaturänderung einer Batteriezelle 101 hervorgerufen wird und nicht aufgrund einer äußeren Kraft, die zu einer Verformung des Temperatursensors 10 am Anbauort AO führt, ist es erfindungsgemäß vorgesehen, dass der Temperatursensor 10 am Anbauort AO von einem starren Schutzelement 30 umgeben ist. Dabei bilden die Glasfaserleiter 11 bis 13 zusammen mit den optischen Elementen 21, 22 und dem Schutzelement 30 eine Baugruppe 31 aus, die mit der Oberfläche der Batteriezelle 101 zumindest thermisch verbunden ist.

Beispielhaft ist das Schutzelement 30 rohrförmig bzw. als Rohr ausgebildet und besteht beispielsweise aus einer Keramik oder einem Glaswerkstoff wie Glaslot oder einem Kunststoff wie Polyetheretherketon (PEEK), Polytetrafluorethylen (PTFE), Polyethylenterephthalat (PET), Kunstharz, Epoxidharz (EP).

Um eine Einkopplung elektrischer Spannungen bzw. Ströme in den Temperatursensor 10 bzw. in die Batteriezelle 101 zu vermeiden, weist das Material des Schutzelements 30, wie bei den oben beispielhaft genannten Materialien bereits vorhanden, elektrisch isolierende oder elektrisch schlecht leitende Eigenschaften auf. Alternativ oder zusätzlich kann das Schutzelement 30 zumindest an der Kontaktfläche zur Batteriezelle 101 mit einer elektrisch isolierenden Beschichtung ausgestattet sein (nicht dargestellt).

Die Starrheit des Schutzelements 30 kann materialabhängig auch durch eine entsprechende Dimensionierung der Wandstärke o.ä. des Schutzelements 30 erreicht werden.

Die Starrheit des Schutzelements kann entsprechend der erwarteten äusseren Kräfte angepasst sein. So kann beispielsweise die Dimensionierung der Wandstärke bei gegebenen Material des Schutzelements 30 entsprechend gewählt sein.

Bevorzugt weist das Schutzelement 30 eine gute Wärmeleitfähigkeit auf, um die an der Batteriezelle 101 aktuell herrschende Temperatur T schnell in das Schutzelement 30 und die Gasfaserleiter 11 bis 13 einzuleiten. Hierzu ist es vorgesehen, dass das Material des Schutzelements 30 aus einem Material besteht, das eine Wärmeleitfähigkeit von mindestens 0,1 Watt je Meter und Kelvin (W / (m.K)) aufweist.

Vorzugsweise ist das Schutzelement 30 geradlinig ausgebildet, es kann jedoch auch beispielsweise eine Krümmung aufweisen. Im dargestellten Ausführungsbeispiel ist darüber hinaus der Glasfaserstrang 15 radial in unmittelbarem Anlagekontakt mit dem Schutzelement 30 angeordnet. Eine derartige unmittelbare Anlage bzw. ein derartiger Anlagekontakt kann beispielsweise durch einen Fügevorgang wie Einpressen oder Aufschrumpfen erfolgen. Alternativ kann es auch vorgesehen sein, dass der Glasfaserstrang 15 über einen Wärmeleitkleber o.ä. Medium mit dem Schutzelement 30 verbunden ist.

Es ist dabei nicht zwingend nötig, dass das Schutzelement im direkten Anlagekontakt zum Glasfaserleiter 11 bis 13 ist. Es hat sich gezeigt, dass auch ein Luftspalt zwischen Glasfaserleiter 11 bis 13 und Schutzelement 30 eine genaue Messung der Temperatur in einer Batteriezelle ermöglicht. Das Schutzelement ist dann vom optischen Element 21,22 durch den Luftspalt beabstandet und beidseitig mit dem Glasfaserleiter 11 bis 13 in einem Bereich verbunden, in dem kein optisches Element 21,22 angeordnet ist (nicht dargestellt). Ein Luftspalt kann auch mit einem Gas gefüllt sein. Ein Vakuumspalt ist jedoch nicht geeignet.

Weiterhin ist es vorteilhaft, auch einen guten Wärmeübergang von der Oberfläche der Batteriezelle 101 zum Schutzelement 30 sicherzustellen. Im dargestellten Ausführungsbeispiel ist hierzu ein Wärmeleitkleber 32 vorgesehen, der neben dem guten Wärmeübergang auch in bekannter Art und Weise für die sichere Befestigung des Schutzelements 30 an der Oberfläche der Batteriezelle 101 sorgt.

Für den Fall, dass das Schutzelement 30 aus einem Glaswerkstoff besteht, ist es bevorzugt vorgesehen, dass der Glaswerkstoff die gleiche chemische Zusammensetzung aufweist wie das Material der Glasfaserleiter 11 bis 13 bzw. der Glasfaserstrang 15. Weiterhin kann in diesem Fall das Material für das Schutzelement 30 auch dazu benutzt werden, die Verbindung mit der Batteriezelle 101 sicherzustellen, insbesondere bei der Verwendung von Glaslot.

Der soweit beschriebene Temperatursensor 10 kann in vielfältiger Art und Weise abgewandelt bzw. modifiziert werden, ohne vom Erfindungsgedanken abzuweichen. So kann es beispielsweise vorgesehen sein, das Schutzelement 30 nicht mit einem rohrförmigen Querschnitt auszustatten, sondern mit einem rechteckförmigen Querschnitt, wobei der Querschnitt für die Glasfaserleiter 11 bis 13 auf der der Batteriezelle 101 abgewandten Seite eine Aufnahmenut für die Glasfaserleiter 11 bis 13 aufweist, in die diese eingebettet und fixiert sind. In diesem Fall sorgt die der Batteriezelle 101 zugewandte ebene Seite des Querschnitts des Schutzelements 30 auch für einen besonders guten Wärmeübergang bzw. eine große Kontaktfläche.

### Bezugszeichenliste

- 1: Sensoreinrichtung
- 2: Steuereinrichtung
- 10: Temperatursensor
- 11: Glasfaserleiter
- 12: Glasfaserleiter
- 13: Glasfaserleiter
- 15: Glasfaserstrang
- 17: Einrichtung
- 21: Element
- 22: Element
- 25: Auswerteeinrichtung
- 30: Schutzelement
- 31: Baugruppe
- 32: Wärmeleitkleber
- 100: Batteriezellenanordnung
- 101: Batteriezelle
- a: Abstand
- AO: Anbauort

## Patentansprüche

1. Optisch arbeitender Temperatursensor (10), mit wenigstens einer Glasfaserleiter (11 bis 13) zur Führung von Lichtstrahlen, mit mehreren, in der wenigstens einen Glasfaserleiter (11 bis 13) axial zueinander beabstandet angeordneten optischen Elementen (21, 22) zur Beeinflussung der in die wenigstens eine Glasfaserleiter (11 bis 13) einleitbaren Lichtstrahlen, wobei die optischen Elemente (21, 22) und der wenigstens einen Glasfaserleiter (11 bis 13) zwischen den optischen Elementen (21, 22) zusammen mit einem starren Schutzelement (30) eine Baugruppe (31) ausbilden, wobei das Schutzelement (30) zumindest auf der einer Oberfläche eines Messobjekts zugewandten und mit dem Messobjekt verbindbaren Seite elektrisch isoliert ausgebildet ist.

2. Temperatursensor nach Anspruch 1, wobei das Schutzelement (30) aus einem Material mit einer Wärmeleitfähigkeit von mindestens 0,1 W / (m·K) besteht.

3. Temperatursensor nach Anspruch 1 oder 2, **dadurch gekennzeichnet, dass** das Schutzelement (30) als Rohr ausgebildet ist.

4. Temperatursensor nach Anspruch 3, **dadurch gekennzeichnet, dass** das Schutzelement (30) als geradlinig ausgebildetes Rohr ausgebildet ist.

5. Temperatursensor nach einem der Ansprüche 1 bis 4, **dadurch gekennzeichnet, dass** das Material des Schutzelements (30) aus einer Keramik oder aus einem Glaswerkstoff oder aus Kunststoff, beispielsweise aus Polyetheretherketon (PEEK), Polytetrafluorethylen (PTFE), Polyethylenterephthalat (PET), Kunstharz, Epoxidharz (EP)besteht.

6. Temperatursensor nach einem der Ansprüche 1 bis 5, **dadurch gekennzeichnet, dass** der wenigstens eine Glasfaserleiter (11 bis 13) und das Schutzelement (30) unmittelbar miteinander verbunden sind.

7. Temperatursensor nach einem der Ansprüche 1 bis 5, **dadurch gekennzeichnet, dass** der wenigstens eine Glasfaserleiter (11 bis 13) und das Schutzelement (30) mittels eines Wärmeleitklebstoffs zumindest zwischen den beabstandet angeordneten optischen Elementen 21, 22 und mit den optischen Elementen 21, 22 verbunden sind.

8. Temperatursensor nach einem der Ansprüche 1 bis 5, **dadurch gekennzeichnet, dass** der wenigstens eine Glasfaserleiter (11 bis 13) und das Schutzelement (30) zumindest im Bereich der optischen Elementen (21, 22) durch einen Luftspalt beabstandet sind; und dass das Schutzelement (30) zumindest an dessen axialen Enden mit dem wenigstens einen Glasfaserleiter (11 bis 13) stoffschlüssig verbunden ist.

9. Temperatursensor nach Anspruch 7, **dadurch gekennzeichnet, dass** der wenigstens eine Glasfaserleiter (11 bis 13) und das Schutzelement (30) mittels eines Wärmeleitklebstoffs o.ä. Mediums thermisch miteinander gekoppelt sind.

10. Temperatursensor nach einem der Ansprüche 1 bis 7, **dadurch gekennzeichnet, dass** bei der Verwendung von Glaswerkstoff für das Schutzelement (30) der Glaswerkstoff die gleiche chemische Zusammensetzung aufweist wie der wenigstens eine Glasfaserleiter (11 bis 13).

11. Temperatursensor nach einem der Ansprüche 1 bis 10, **dadurch gekennzeichnet, dass** der Temperatursensor (10) dazu ausgebildet ist, eine Temperaturerfassung aufgrund einer FSI-Technologie zu ermöglichen.

12. Temperatursensor nach einem der Ansprüche 1 bis 10, **dadurch gekennzeichnet, dass** der Temperatursensor (10) dazu ausgebildet ist, eine Temperaturerfassung aufgrund einer FBG-Technologie zu ermöglichen.

13. Verwendung eines Temperatursensors (10), der nach einem der Ansprüche 1 bis 12 ausgebildet ist, zur Erfassung der Oberflächentemperatur einer Batteriezelle (101), insbesondere einer Batteriezelle (101) eines Elektrofahrzeugs.

14. Batteriezellenanordnung (100) eines Elektrofahrzeugs, mit mehreren Batteriezellen (101) und wenigstens einem, vorzugsweise mehreren Temperatursensoren (10), die nach einem der Ansprüche 1 bis 12 ausgebildet sind, wobei der wenigstens eine Temperatursensor (10) wärmeleitend mit einer Oberfläche einer Batteriezelle (101) verbunden.
